# EUROPÄISCHE PATENTSCHRIFT

(11) **EP 0 555 547 B1**
(45) Veröffentlichungstag und Bekanntmachung des Hinweises auf die Patenterteilung: **12.06.1996**
(21) Anmeldenummer: 92121411.0
(22) Anmeldetag: 16.12.1992
(51) Int. Cl.: H03K 3/023

(54) **Schmitt-Trigger**
Schmitt trigger
Trigger de Schmitt

(30) Priorität: 13.02.1992 DE 4204297
(43) Veröffentlichungstag der Anmeldung: 18.08.1993
(73) Patentinhaber: SIEMENS AKTIENGESELLSCHAFT, D-80333 München (DE)
(72) Erfinder: Lenz, Michael, W-8011 Zorneding (DE)

(56) Entgegenhaltungen:
- EP-A- 0 389 156
- DE-A- 3 835 797
- PATENT ABSTRACTS OF JAPAN vol. 12, no. 177 (E-613)25. Mai 1988
- PATENT ABSTRACTS OF JAPAN vol. 8, no. 804 (E-239)18. April 1984

## Beschreibung

Die Erfindung betrifft einen Schmitt-Trigger gemäß dem Oberbegriff des Anspruchs 1.

Ein derartiger Schmitt-Trigger ist aus DE-A-3 835 797 bekannt. Hierbei liegen die Begrenzungsschwellen jeweils auf einem festen Potential.

Ein weiterer Schmitt-Trigger ist in Tietze/Schenk Halbleiterschaltungstechnik 8. Auflage 1986 auf Seite 168ff beschrieben. Soll das Ausgangssignal einer Differenzstromquelle, z. B. eines OTA, dem Eingang des Schmitt-Triggers zugeführt werden, so ist es notwendig, das Ausgangssignal der Differenzstromquelle zu begrenzen, wenn der Eingang des Schmitt-Triggers hochohmig ausgelegt ist, um so eine Zerstörung der Differenzstromquelle zu vermeiden. Derartige Begrenzerschaltungen sind z. B. auf Seite 214 in Abbildung 9.3 der oben zitierten Schrift dargestellt. Die Schaltschwellen des Schmitt-Triggers müssen dann bei einer derartigen Anordnung zwischen der oberen Begrenzungsschwelle und der unteren Begrenzungsschwelle liegen. Das Ausgangssignal der Differenzstromquelle kann somit den Bereich zwischen unterer Begrenzungsschwelle und oberer Begrenzungsschwelle durchlaufen. Je nach Über- oder Unterschreiten der oberen bzw. unteren Schmitt-Trigger-Schwelle wird das Ausgangssignal des SchmittTriggers umgeschaltet.

Aufgrund der Begrenzer- und Schmitt-Trigger-Schwellen insbesondere deren kapazitiven Belastung, ergibt sich eine Verzögerungszeit die sich positiv bzw. negativ auswirkt und die von der Anstiegszeit des Differenzstromquellenausgangssignals und der Schwellenkonstanz abhängig ist. Die Verzögerungszeit, oder auch Totzeit genannt, wird umso größer je größer der Abstand der beiden SchmittTrigger-Schwellen wird. Der Abstand der Schmitt-Trigger-Schwellen wiederum ist ausschlaggebend für eine hohe Störunterdrückung. Diese wird umso größer je größer der Abstand der Schmitt-TriggerSchwellen wird. Dies führt zu einem großen Nachteil beim Abfragen kleiner Analog-Signale, wenn eine hohe Genauigkeit gefordert ist.

Aufgabe der Erfindung ist es, einen Schmitt-Trigger zur Abfrage eines Signals anzugeben, dessen Totzeiten bei gleicher Störunterdrückung minimal werden.

Diese Aufgabe wird durch den kennzeichnenden Teil des Anspruchs 1 gelöst. Weiterbildungen sind Kennzeichen der abhängigen Ansprüche.

Die Erfindung wird nachfolgend anhand von zwei Figuren näher erläutert.
- Figur 1: zeigt ein Prinzipschaltbild der erfindungsgemäßen Anordnung,
- Figur 2: zeigt den zeitlichen Verlauf der oberen und unteren Begrenzungsschwelle sowie der Schmitt-Trigger-Schwelle und den Verlauf eines Eingangssignals.

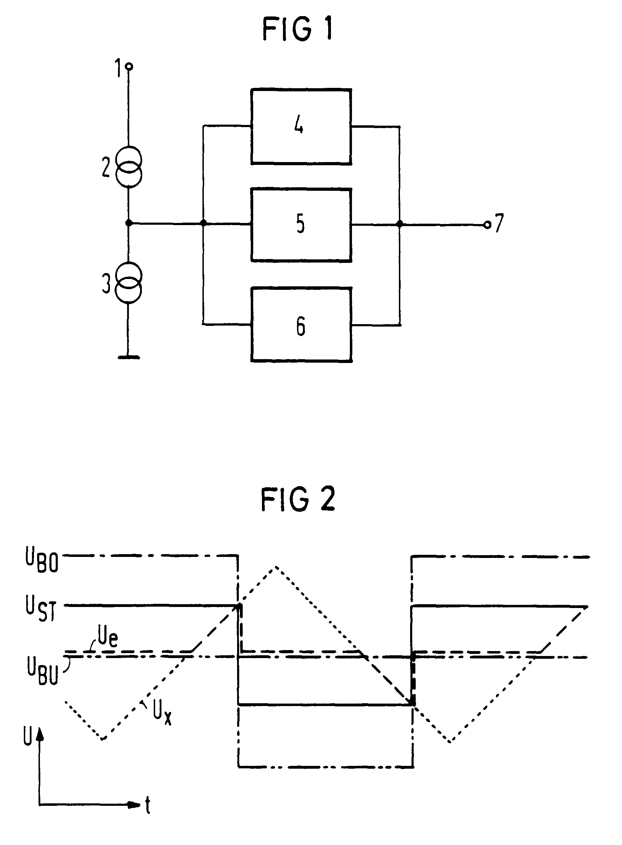

Die in Figur 1 dargestellte Prinzipschaltungsanordnung zeigt eine Differenzstromquelle, die eine erste Stromquelle 2 und eine zweite Stromquelle 3 enthält. Beide Stromquellen 2, 3 sind in Reihe zwischen einer ersten Anschlußklemme 1 und Masse geschaltet. An die Anschlußklemme 1 kann die Versorgungsspannung angelegt werden. Der Verbindungspunkt der Reihenschaltung der beiden Stromquellen 2, 3 führt zum Eingang eines Schmitt-Triggers 5, dessen Ausgang mit einer Ausgangsklemme 7 verbunden ist. Der Eingang des Schmitt-Triggers 5 ist zum einen mit dem Eingang eines ersten Begrenzers 4 und zum anderen mit dem Eingang eines zweiten Begrenzers 6 verschaltet. Beide Begrenzer 4 und 6 sind steuerbar und weisen Steuereingänge auf, die mit dem Ausgang des Schmitt-Triggers 5 verschaltet sind.

Die Begrenzerschwellen des oberen Begrenzers 4 und des unteren Begrenzers 6 werden synchron zur Schmitt-Trigger-Schwelle umgeschaltet. Dieser Vorgang ist in Figur 2 zeitlich dargestellt. Der zeitliche Verlauf der oberen Begrenzungsschwelle U_{BO} ist durch die strichpunktierte Linie dargestellt. Der Verlauf der unteren Begrenzungsschwelle U_{BU} ist ebenfalls durch eine strichpunktierte Linie und der Verlauf der Schmitt-Trigger-Schwelle U_{ST} durch die durchgezogene Linie dargestellt. Der theoretische Verlauf des Ausgangssignals Uₓ der Differenzstromquelle 2, 3 ist punktiert dargestellt und hat hier beispielsweise die Form eines Dreiecks. Durch die Begrenzer 4 und 6 wird dieses Signal in das Signal Uₑ umgeformt. Dieses Signal Uₑ ist in Figur 2 gestrichelt dargestellt.

Solange das Ausgangssignal Uₓ der Differenzstromquelle unterhalb der Schwelle U_{BU} des unteren Begrenzers 6 liegt, liegt das Eingangssignal Uₑ am Eingang des Schmitt-Triggers 5 in Höhe der unteren Schwelle U_{BU}. Übersteigt das Ausgangssignal Uₓ den Wert der unteren Begrenzerschwelle U_{BO}, so muß es nur den Hub zwischen unterer Begrenzungsschwelle U_{BU} und der Schmitt-Trigger-Schwelle U_{ST} überwinden um das Ausgangssignal des Schmitt-Triggers 5 umzuschalten. Geschieht dies, so werden auch gleichzeitig die obere und untere Schwelle U_{BO}, U_{BU} der Begrenzer 4 und 6 umgeschaltet. Die obere Begrenzungsschwelle U_{BO} wird nun auf den gleichen Wert den zuvor die untere Begrenzungsschwelle U_{BU} inne hatte umgeschaltet. Die Lage der unteren Begrenzungsschwelle wird ebenfalls so umgeschaltet, daß sie unterhalb der Schmitt-Trigger-Schwelle U_{ST} liegt. Hierbei ist der Abstand zwischen Schmitt-Trigger-Schwelle und unterer Begrenzungsschwelle unerheblich, da der untere Begrenzer 6 in dieser Phase nicht aktiv wird. Das gleiche gilt in der vorhergehenden Phase für den oberen Begrenzer 4.

Durch diese Maßnahme hat sich der Hub, den das Ausgangssignal der Differenzstromquelle zurücklegen muß gegenüber bisherigen Anordnungen, bei denen die untere Begrenzungsschwelle U_{BU} grundsätzlich unterhalb der unteren Schmitt-Trigger-Schwelle U_{ST} und die obere Begrenzungsschwelle U_{BO} grundsätzlich oberhalb der oberen Schmitt-Trigger-Schwelle U_{ST} lag auf ca. die halbe Hysterese reduziert. Wie im in Figur 2 dargestellten Fall tritt eine derartige Reduzierung auf, wenn die jeweils aktive Begrenzerschwelle auf den arithmetischen Mittelwert der SchmittTrigger-Schwellen geschaltet wird. Durch diese Anordnung werden die Totzeiten minimal. Streuen die Schwellen, so ändert sich lediglich das Verhältnis der positiven bzw. negativen Totzeit, d. h. derjenigen Zeiten, während der das Signal von der aktiven Begrenzerschwelle zur Schmitt-Trigger-Schwelle ansteigt bzw. abfällt.

Es wären auch andere Werte für die Begrenzungsschwellen denkbar. Die jeweils aktiven Begrenzungsschwellen müssen nicht symetrisch geschaltet werden. So könnte z. B. die jeweils aktive Begrenzerschwelle auch möglichst nah an die Schmitt-Trigger-Schwelle geschaltet werden, um so die Totzeit noch weiter zu minimieren.

## Patentansprüche

1. Schmitt-Trigger zur Abfrage eines Eingangssignals mit einer ersten Begrenzerstufe (4), der das Eingangssignal zuführbar ist und die eine obere Begrenzungsschwelle (U_{BO}) zur oberen Begrenzung des Eingangssignals aufweist, und mit einer zweiten Begrenzerstufe (6), der das Eingangssignal zuführbar ist und die eine untere Begrenzungsschwelle (U_{BU}) zur unteren Begrenzung des Eingangssignals aufweist, wobei der Schmitt-Trigger eine Schmitt-Trigger-Stufe (5) aufweist, der das Eingangssignal zuführbar ist, die ein Ausgangssignal erzeugt und die eine obere und eine untere Trigger-Schwelle aufweist, wobei die obere Schmitt-Trigger-Schwelle unterhalb der oberen Begrenzungsschwelle (U_{BO}) und die untere Trigger-Schwelle oberhalb der unteren Begrenzungsschwelle (U_{BU}) liegt,
**dadurch gekennzeichnet**, daß
die Begrenzungsschwellen (U_{BO}, U_{BU}) der ersten und der zweiten Begrenzungsstufe (4, 6) jeweils steuerbar sind und daß die Begrenzungsschwellen (U_{BO}, U_{BU}) der ersten und der zweiten Begrenzungsstufe (4, 6) vom Ausgangssignal der Schmitt-Trigger-Stufe (5) gesteuert werden.

2. Schmitt-Trigger nach Anspruch 1,
**dadurch gekennzeichnet,** daß
- bei Aktivierung der oberen Trigger-Schwelle des Schmitt-Triggers die untere Begrenzungsschwelle (U_{BU}) möglichst nahe an der oberen Triggerschwelle liegt,
- bei Aktivierung der unteren Trigger-Schwelle des Schmitt-Triggers die obere Begrenzungsschwelle (U_{BO}) möglichst nahe an der unteren Triggerschwelle liegt.

3. Schmitt-Trigger nach Anspruch 1,
**dadurch gekennzeichnet,** daß
bei Aktivierung der oberen Trigger-Schwelle des Schmitt-Triggers die untere Begrenzungsschwelle (U_{BU}) und bei Aktivierung der unteren Trigger-Schwelle die obere Begrenzungsschwelle (U_{BO}) jeweils auf den Mittelwert von oberer und unterer Trigger-Schwelle eingestellt werden.

## Claims

1. Schmitt trigger for the interrogation of an input signal, having a first limiter stage (4) to which the input signal can be fed and which has an upper limiting threshold (U_{BO}) for the upper limiting of the input signal, and having a second limiter stage (6) to which the input signal can be fed and which has a lower limiting threshold (U_{BU}) for the lower limiting of the input signal, the Schmitt trigger having a Schmitt trigger stage (5) to which the input signal can be fed, which generates an output signal and which has an upper and a lower trigger threshold, the upper Schmitt trigger threshold lying below the upper limiting threshold (U_{BO}) and the lower trigger threshold lying above the lower limiting threshold (U_{BU}), characterized in that each of the limiting thresholds (U_{BO}, U_{BU}) of the first and second limiting stages (4, 6) can be controlled, and in that the limiting thresholds (U_{BO}, U_{BU}) of the first and second limiting stages (4, 6) are controlled by the output signal of the Schmitt trigger stage (5).

2. Schmitt trigger according to Claim 1, characterized in that
- when the upper trigger threshold of the Schmitt trigger is activated, the lower limiting threshold (U_{BU}) lies as close as possible to the upper trigger threshold,
- when the lower trigger threshold of the Schmitt trigger is activated, the upper limiting threshold (U_{BO}) lies as close as possible to the lower trigger threshold.

3. Schmitt trigger according to Claim 1, characterized in that when the upper trigger threshold of the Schmitt trigger is activated, the lower limiting threshold (U_{BU}) is set to the mean value of the upper and lower trigger thresholds, and when the lower trigger threshold is activated, the upper limiting threshold (U_{BO}) is set to the mean value of the upper and lower trigger thresholds.

## Revendications

1. Trigger de Schmitt d'interrogation d'un signal d'entrée, comportant un premier étage (4) limiteur, auquel peut être envoyé le signal d'entrée et qui comporte un seuil supérieur (U_{BO}) de limitation par le haut du signal d'entrée, et un second étage (6) limiteur, auquel peut être envoyé le signal d'entrée et qui comporte un seuil (U_{BU}) inférieur de limitation par le bas du signal d'entrée, le Trigger de Schmitt comportant un étage (5) de Trigger de Schmitt, auquel peut être envoyé le signal d'entrée, qui produit un signal de sortie et qui comporte un seuil supérieur et un seuil inférieur de Trigger de Schmitt, le seuil supérieur de Trigger de Schmitt étant au-dessous du seuil supérieur (U_{BO}) de limitation et le seuil inférieur de Trigger de Schmitt étant au-dessus du seuil (U_{BU}) inférieur de limitation,
caractérisé en ce que
les seuils (U_{BO}, U_{BU}) de limitation des premier et second étages (4,6) de limitation peuvent chacun être commandés et les seuils (U_{BO}, U_{BU}) de limitation des premier et second étages (4,6) de limitation sont commandés par le signal de sortie de l'étage (5) de Trigger de Schmitt.

2. Trigger de Schmitt suivant la revendication 1,
caractérisé en ce que
- lorsque le seuil supérieur du Trigger de Schmitt est activé, le seuil inférieur (U_{BU}) de limitation est le plus proche possible du seuil supérieur du Trigger de Schmitt,
- lorsque le seuil inférieur du Trigger de Schmitt est activé, le seuil supérieur (U_{BO}) de limitation est le plus proche possible du seuil inférieur de Trigger de Schmitt.

3. Trigger de Schmitt suivant la revendication 1,
caractérisé en ce que
lorsque le seuil supérieur du Trigger de Schmitt est activé, le seuil (U_{BU}) inférieur de limitation est réglé à la valeur moyenne du seuil supérieur et du seuil inférieur du Trigger de Schmitt et lorsque le seuil inférieur du Trigger de Schmitt est activé, le seuil supérieur (U_{BO}) de limitation est réglé à la valeur moyenne des seuils supérieur et inférieur du Trigger de Schmitt.
